# EUROPEAN PATENT APPLICATION

(11) **EP 4 521 593 A2**
(43) Date of publication of application: **12.03.2025**
(21) Application number: 24191546.1
(22) Date of filing: 29.07.2024
(51) Int. Cl.: H02J 7/00, G01R 31/3835, G01R 31/67

(54) **APPARATUS AND METHOD FOR COMPENSATING OCV OF BATTERY**

(30) Priority: 06.09.2023 KR 20230118342
(71) Applicant: SAMSUNG SDI CO., LTD., Giheung-gu Yongin-si, Gyeonggi-do 17084 (KR)
(72) Inventor: LEE, Kyung Sub, 16678 Suwon-si (KR)
(74) Representative: Marks & Clerk LLP

(57) **Abstract**

Disclosed are an apparatus and method for compensating an an open-circuit voltage (OCV) of a battery. The apparatus for compensating an open-circuit voltage of a battery of the present disclosure includes a voltage sensor configured to detect a voltage of a battery cell, and a processor configured to extract a voltage value and a state-of-charge (SOC) value of a peak within a preset voltage section for each preset set cycle based on a voltage value of the battery cell detected by the voltage sensor each time the preset set cycle elapses and compensate an OCV using the SOC value for each peak and a voltage variation amount of the peak.

## Description

### BACKGROUND

### 1. Field

Aspects of embodiments of the present disclosure relate to an apparatus and method for compensating an open-circuit voltage (OCV) of a battery.

### 2. Description of the Related Art

A battery management system (BMS) is equipped with an algorithm for estimating a battery state. The algorithm estimates an internal state of a battery utilizing information capable of being measured outside the battery (such as voltage, current, temperature, and the like). In addition, the algorithm is being expanded to be utilized to various element technologies (such as capacity estimation, rapid charging, diagnostic functions, and the like) utilizing the estimated information.

The algorithm utilizes various element technologies to provide users with more accurate information and may, for example, detect and prevent abnormal phenomena such as a battery fire or explosion in advance. For these purposes, it may be desired for the algorithm to accurately estimate the internal state of the battery even in diverse or harsh environments, which may involve precise model construction and control to prevent errors from occurring.

However, a direction or degree of battery aging may vary depending on the usage environment, so the estimation accuracy of the algorithm may decrease. In addition, errors in estimated capacity can accumulate each time the battery is exposed to a harsh environment, and an error variation of capacity information, which is reduced due to deterioration, may also increase over time. Consequently, problems with the increased likelihood of an accident caused by the battery, reduced battery usage efficiency, or the like, may occur.

### SUMMARY

Some aspects of the present invention are directed to providing an apparatus and method for more simply and precisely compensating an open-circuit voltage (OCV) of a battery for a state of charge (SOC) based on an aging direction of a battery cell.

According to an aspect of the present invention, there is provided an apparatus for compensating an open-circuit voltage (OCV) of a battery, the apparatus including a voltage sensor configured to detect a voltage of a battery cell of the battery, and a processor configured to determine a voltage value and a state-of-charge (SOC) value of a peak within a voltage range based on the voltage of the battery cell each time a set number of cycles elapses, to determine a voltage variation amount of the peak, and to compensate an OCV using the SOC value for each peak and the voltage variation amount of the peak.

The processor may be configured to determine the voltage value and the SOC value of the peak within the voltage range in response to a plateau section being identified in a variation of cell voltage over cell capacity corresponding to the battery cell.

The processor may be configured to identify the peak in the voltage range in which a capacity variation amount divided by a voltage variation amount is equal to or greater than a reference value by utilizing incremental capacity analysis (ICA) during a constant current charging or discharging process of the battery cell.

The processor may be configured to add the voltage variation amount for the SOC value to an OCV value.

The processor may be configured to identify a voltage variation amount function corresponding to the SOC value and to calculate the voltage variation amount for the SOC value using the voltage variation amount function.

The processor may be configured to identify the voltage variation amount function using at least one of constant processing, interpolation/extrapolation, a cut method, and a curve fitting method based on a number of peaks.

The processor may be configured to process the voltage variation amount function as a constant in response to the number of identified peaks being one.

The processor may be configured to identify the voltage variation amount function through at least one of the interpolation/extrapolation, the cut method, and the curve fitting method in response to the number of identified peaks being two or more.

According to another aspect of the present disclosure, there is provided a method for compensating an OCV of a battery, the method including determining, by a processor, a voltage value and an SOC value of a peak within a voltage range, based on a voltage value of a battery cell detected by a voltage sensor and compensating, by the processor, the OCV using the SOC value for the peak and a voltage variation amount of the peak.

In the determining of the voltage value and the SOC value of the peak within the voltage range for each cycle, the processor may determine the voltage value and the SOC value of the peak within the voltage range in response to a plateau section being identified in the battery cell.

In the determining of the voltage value and the SOC value of the peak within the voltage range for each cycle, the processor may identify the peak in the voltage range in which a capacity variation amount divided by a voltage variation amount is equal to or greater than a reference value by utilizing incremental capacity analysis (ICA) during a constant current charging or discharging process of the battery cell.

In the compensating of the OCV, the processor may add the voltage variation amount for the SOC value to an OCV value.

In the compensating of the OCV, the processor may determine a voltage variation amount function corresponding to the SOC value and calculate the voltage variation amount for the SOC value using the voltage variation amount function.

In the compensating of the OCV, the processor may determine the voltage variation amount function using at least one of constant processing, interpolation/extrapolation, a cut method, and a curve fitting method based on a number of identified peaks.

In the compensating of the OCV, the processor may process the voltage variation amount function as a constant in response to the number of peaks being one.

In the compensating of the OCV, the processor may determine the voltage variation amount function through at least one of the interpolation/extrapolation, the cut method, and the curve fitting in response to the number of peaks being two or more.

At least some of the above and other features of the invention are set out in the claims.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is a block diagram of an apparatus for compensating an open-circuit voltage (OCV) of a battery according to one embodiment of the present disclosure;
FIG. 2 is a graph showing a voltage of a battery cell versus a capacity of the battery cell according to one embodiment of the present disclosure;
FIG. 3 is a graph showing a peak shift in a plateau section in a variation of cell voltage over cell capacity corresponding to the battery cell, according to one embodiment of the present disclosure;
FIG. 4 presents graphs showing a peak voltage variation amount before and after aging progresses of a battery cell according to one embodiment of the present disclosure;
FIG. 5 presents graphs showing a voltage variation amount function and a compensated OCV for a state of charge (SOC) according to one embodiment of the present disclosure;
FIG. 6 is a graph showing an OCV to which a voltage variation amount function is applied according to one embodiment of the present disclosure;
FIG. 7 presents graphs showing an example of determining a voltage variation amount according to one embodiment of the present disclosure; and
FIG. 8 is a flowchart of a method for compensating an OCV of a battery according to one embodiment of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of' and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

Hereinafter, an apparatus and method for compensating an open-circuit voltage (OCV) of a battery according to one embodiment of the present disclosure will be described in detail with reference to the accompanying drawings. In this process, thicknesses of lines, dimensions of elements, and the like shown in the drawings may be exaggerated for clarity and convenience. Also, terms described below may be defined in consideration of functions in the present disclosure, and may be changed depending on the customary practice or the intention of a user or operator. Thus, definitions of such terms should be determined based on the overall content of the present specification.

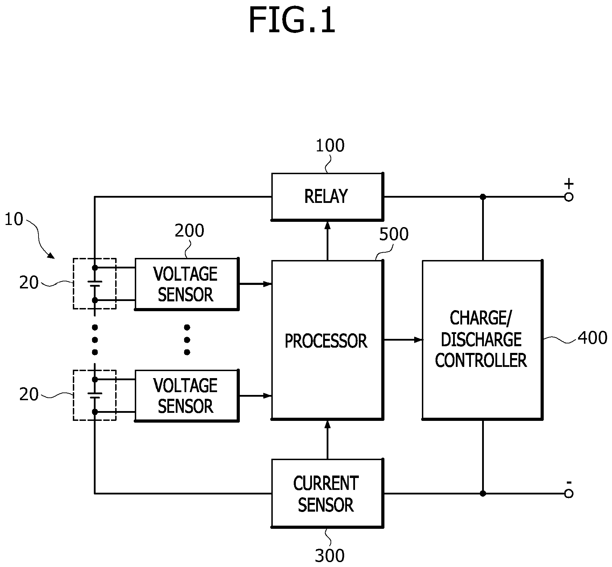

FIG. 1 is a block diagram of an apparatus for compensating an OCV of a battery according to one embodiment of the present disclosure.

Referring to FIG. 1, the apparatus for compensating an OCV of a battery according to one embodiment of the present disclosure includes a voltage sensor 200, a relay 100, a current sensor 300, a charge/discharge controller 400, and a processor 500.

The battery 10 may be connected in series with a terminal of an external device (not shown).

The battery 10 may supply power to the external device, or may be charged by receiving power from the external device.

The external device may be a load of an electric vehicle or hybrid vehicle, but its type is not particularly limited.

The battery 10 may include a plurality of battery cells 20 connected in series, parallel, or a combination of both.

Each of the battery cells 20 may be at least one of a lithium ion battery or a lithium polymer battery.

The relay 100 regulates electrical connection between the battery 10 and the external device. That is, the relay 100 may be turned on according to a control signal from the processor 500 to electrically connect the battery 10 and the external device. In this case, the battery 10 may supply power to the external device or may be charged by receiving power from the external device. In examples, the relay 100 may be turned off according to a control signal from the processor 500 to electrically disconnect the battery 10 and the external device.

The relay 100 may be installed between a positive electrode of the battery 10 and the external device. Alternatively, the relay 100 may also be installed between a negative electrode of the battery 10 and the external device. An installation location of the relay 100 is not particularly limited.

The voltage sensor 200 may be connected to a positive electrode and a negative electrode of the battery cell 20.

The voltage sensor 200 may detect a voltage of the battery cell 20 and input the detected voltage into (e.g. provide the current measurement to) the processor 500.

The current sensor 300 may be connected between the negative electrode of the battery cell 20 and the external device.

The current sensor 300 may detect a current when the battery cell 20 is charged or discharged and input the detected current into the processor 500.

The current sensor 300 may be a Hall current transformer (CT) that measures a current using a Hall element and outputs an analog current signal corresponding to the measured current.

The charge/discharge controller 400 controls charging or discharging of the battery 10.

The charge/discharge controller 400 may control constant current charging or discharging of the battery 10 according to a control signal from the processor 500. The charge/discharge controller 400 may include a plurality of switch elements for constant current charging or discharging of the battery 10, and may control current flow during charging or discharging according to switching states of the switch elements. The switch elements may be MOSFETs, but are not particularly limited.

The processor 500 may identify a battery cell 20 in which a plateau section appears (in a variation of cell voltage over cell capacity corresponding to the battery cell) using a voltage value of each battery cell 20 detected by the voltage sensor 200.

In addition, each time a preset set cycle (e.g., each time a set number of charge or discharge cycles) elapses, the processor 500 may determine (e.g. extract) a voltage value and a state-of-charge (SOC) value (as, e.g., measured by changes in capacity (i.e., amperes-hours) over changes in voltage, i.e., ΔAh/ΔV) of a peak (as described below) within a preset voltage section (e.g. within a set voltage range) based on the voltage value of the battery cell 20 in which the plateau section appears.

The cycle may be a charge cycle or a discharge cycle (e.g., a constant current charge or discharge cycle of the battery cell).

The processor 500 may compensate an OCV using the SOC value for each peak and the voltage variation amount of the peak (i.e., the amount by which the peak is shifted in voltage).

For example, the processor 500 may control the relay 100 to electrically connect the battery 10 and the external device.

The processor 500 may control the charging and discharging of the battery 10 by controlling the charge/discharge controller 400.

In addition, each time the preset set cycle elapses (e.g., each time a set number of charge or discharge cycles elapses), the processor 500 may determine whether or not a plateau section appears for each battery cell 20 based on the voltage measurements of each battery cell 20 detected by the voltage sensor 200 in the corresponding cycle.

The set cycle is a cycle at which the voltage variation (i.e. the voltage shift) of the peak, which will be described below, is capable of being sufficiently determined. The set cycle is not particularly limited.

The plateau section may be defined as a section of voltage measurements in which the sensed voltage does not vary significantly (e.g. is less than or equal to the threshold) as the cell capacity changes during the charging and discharging process.

In order to check whether or not the plateau section appears, the processor 500 may first determine (e.g. extract) a voltage variation amount of the battery cell 20 during the process of charging and discharging the battery 10 through the charge/discharge controller 400. The processor 500 may determine whether the voltage variation amount of the corresponding battery cell 20 is less than or equal to a threshold, and determine that the plateau section appears in the corresponding battery cell 20 when the voltage variation amount of the battery cell 20 is less than or equal to the threshold.

The threshold is a voltage variation amount for determining whether the plateau section appears. When the voltage variation amount of the battery cell 20 is less than or equal to the threshold, it may be determined that the plateau section appears in the battery cell 20.

The processor 500 repeatedly checks whether the plateau section appears each time the set cycle elapses for each battery cell 20.

The processor 500 performs incremental capacity analysis (ICA) on the battery cell 20 in which the plateau section appears.

The ICA is a method for more precisely estimating the voltage or capacity of the battery cell 20.

The processor 500 determines whether the capacity variation amount divided by a voltage variation amount is equal to or greater than a reference value (e.g. preset reference value) using the ICA during a constant current charging or discharging process of the battery cell, and identifies (e.g. extracts) a voltage section in which the capacity variation amount divided by a voltage variation amount is equal to or greater than the reference value. Then, the processor 500 identifies (e.g. sets) a peak in the identified (e.g. extracted) voltage section (e.g. voltage range).

Here, the reference value is a capacity variation amount/voltage variation amount set in advance to identify (e.g. set) a peak.

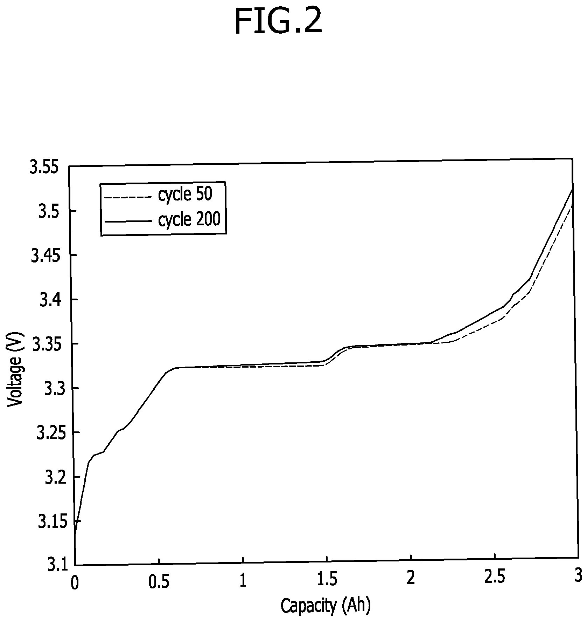

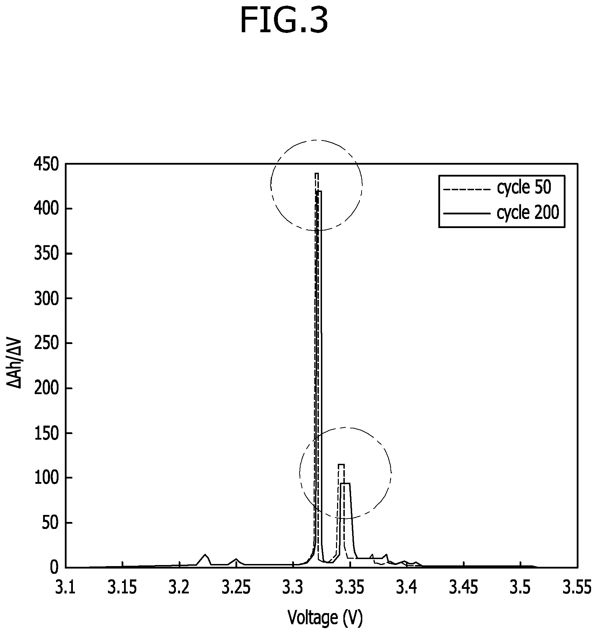

FIG. 2 is a graph showing a voltage of a battery cell versus a capacity of the battery cell according to embodiments of the present disclosure. FIG. 3 is a graph showing peak shifts in a plateau section of the graph of FIG. 2, according to embodiments of the present disclosure.

In general, the capacity variation amount of the battery cell 20 in which the plateau section appears is greater than the voltage variation amount thereof. Accordingly, the processor 500 may identify (e.g. set) peaks as shown in FIG. 3 when the ICA is applied to the battery cell 20.

The processor 500 stores voltages and SOC values (as, e.g., measured by changes in capacity (i.e., amperes-hours) over changes in voltage, i.e., ΔAh/ΔV) at points where peaks are identified (e.g. set).

In FIG. 2, the dashed line represents voltage versus a capacitance in the 50th cycle (e.g. charge or discharge cycle), and the solid line repreents voltage versus a capacitance in the 200th cycle.

When the ICA is performed on the battery cell 20 during a constant current charging or discharging process of the battery cell, peaks as shown in FIG. 3 may be identified (e.g. extracted). In the circles in FIG. 3, the peaks in the 50th cycle and the peaks in the 200th cycle are shown.

The peaks may be shifted right and downward (i.e., toward higher voltage and lower delta capacity over delta voltage) due to factors such as a decrease in maximum capacity or an increase in voltage as the number of cycles of the battery cell 20 increases or as the battery cell 20 ages.

That is, referring to FIG. 3, it can be seen that the peak voltages in the 50th cycle are shifted right and downward at the 200th cycle after 150 cycles have elapsed.

Therefore, the processor 500 may calculate the voltage variation amount of each peak. The voltage variation amount of a peak is the amount by which the peak is shifted.

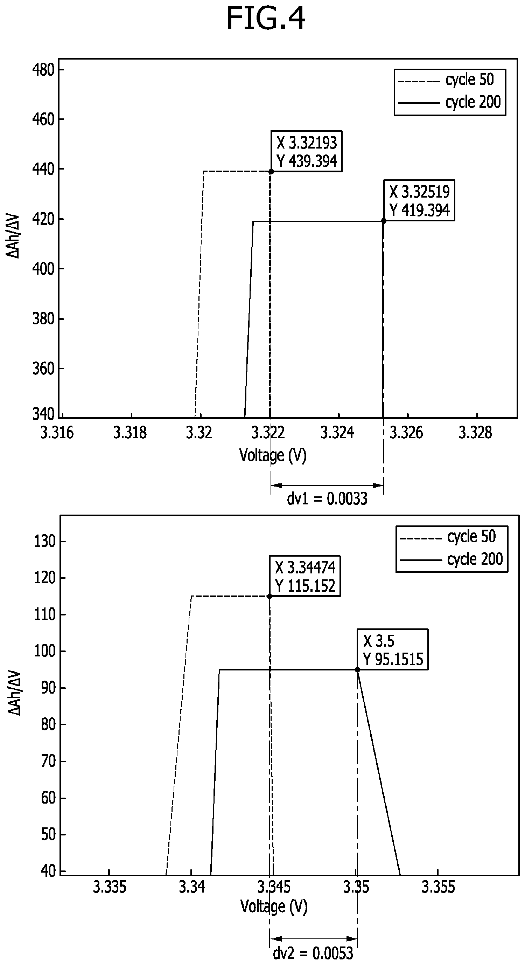

FIG. 4 presents graphs showing the peak voltage variation amount (e.g., a peak voltage shift) before and after aging progresses of a battery cell according to some embodiments of the present disclosure. The top and bottom graph of FIG. 4 respectively correspond to the first peak and the second peak illustrated in FIG. 3.

Referring to FIG. 4, when two peaks are identified (e.g. set) in the battery cell 20, two peak voltage variation amounts dv 1 and dv2 may be obtained from voltages of two peaks in the 50th cycle and voltages of two corresponding peaks in the 200th cycle after 150 cycles have elapsed. In this example, dv1 is approximately 0.0033 (i.e. 3.32519-3.32193) V, and dv2 is approximately 0.0053 (i.e. 3.35-3.34474) V.

Then, the processor 500 calculates a voltage variation amount function for the SOC using the previously stored SOC value at each cycle (e.g. charge or discharge cycle) and the voltage variation amount between voltages in the cycles.

That is, the processor 500 determines (e.g. extracts) the voltage variation amount function for the SOC value (i.e., the voltage variation amount as a function of SOC) using two SOC values in the 50th cycle and two SOC values in the 200th cycle, and the voltage variation amount (e.g. the amount of voltage shift) between the peak voltages in the 50th cycle and the 200th cycle.

The processor 500 calculates the voltage variation amount for each SOC value using the determined (e.g. extracted) voltage variation amount function.

The processor 500 adds the calculated voltage variation amount for each SOC to the OCV of the existing SOC value.

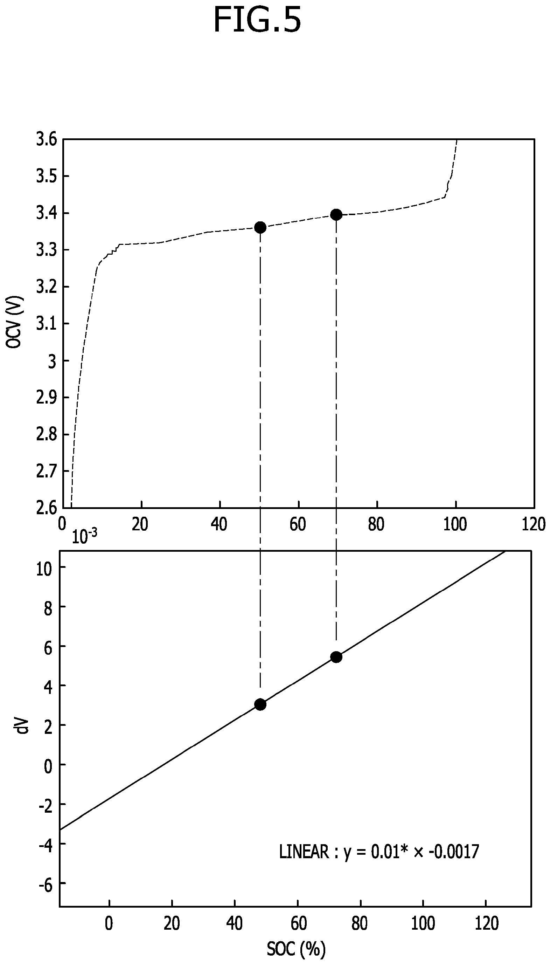

FIG. 5 presents graphs showing a voltage variation amount function and a compensated OCV for an SOC according to one embodiment of the present disclosure. The x-axis of these graphs represents the SOC percentage.

Referring to FIG. 5, a voltage variation amount function is y=0.01 * x -0.0017, where y represents the change in voltage (dV) and x represents the percentage of SOC). Two points defining the variation amount function are the peak variation amounts are dv1 (0.0033) and dv2 (0.0053).

Accordingly, the processor 500 may calculate the voltage variation amount for a given SOC value using the voltage variation amount function. The processor 500 may compensate the OCV by adding the voltage variation amount for the calculated SOC value to the existing OCV

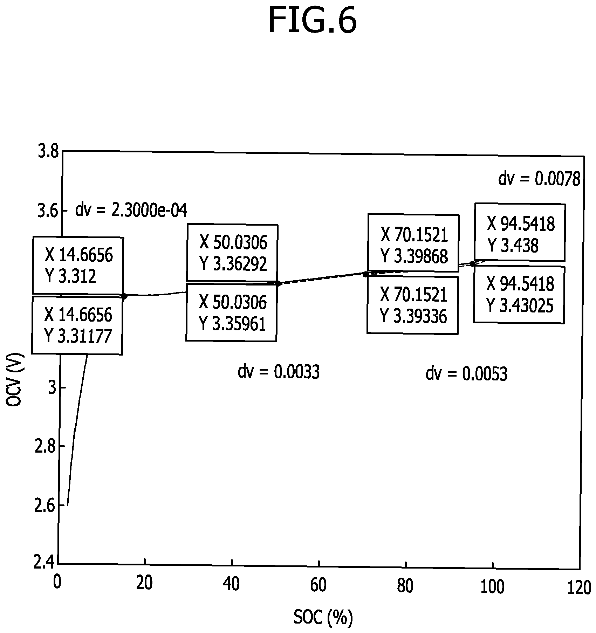

FIG. 6 is a graph showing an OCV to which a voltage variation amount function is applied according to embodiments of the present disclosure.

Referring to FIG. 6, a compensated OCV obtained by adding the voltage variation amount between dv1 and dv2 to the existing OCV is shown.

The processor 500 may determine (e.g. extract) the voltage variation amount function in various ways depending on the number of peaks. The processor 500 may use at least one of constant processing, interpolation/extrapolation, a cut method, and curve fitting.

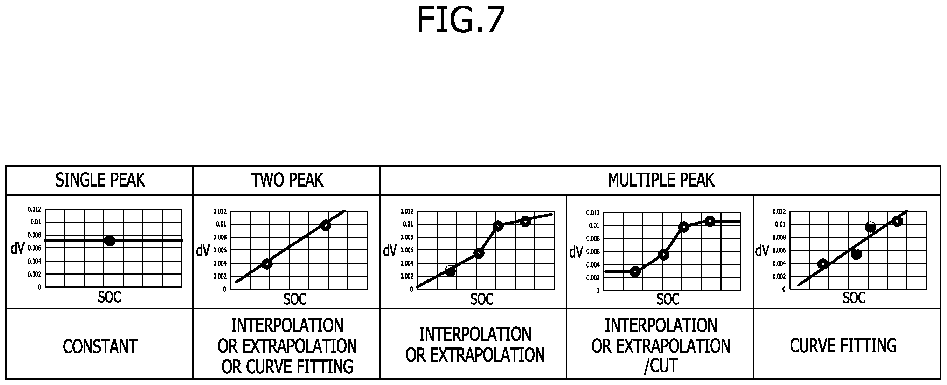

FIG. 7 is a view showing examples of determining (e.g. extracting) a voltage variation amount according to embodiments of the present disclosure.

Referring to FIG. 7, the processor 500 processes the voltage variation amount function as a constant when the number of peaks is one.

The processor 500 determines (e.g. extracts) the voltage variation amount function using interpolation/extrapolation or curve fitting when the number of peaks is two.

The processor 500 may use the interpolation/extrapolation, use the interpolation/extrapolation and a cut method, or use curve fitting when the number of peaks is three or more.

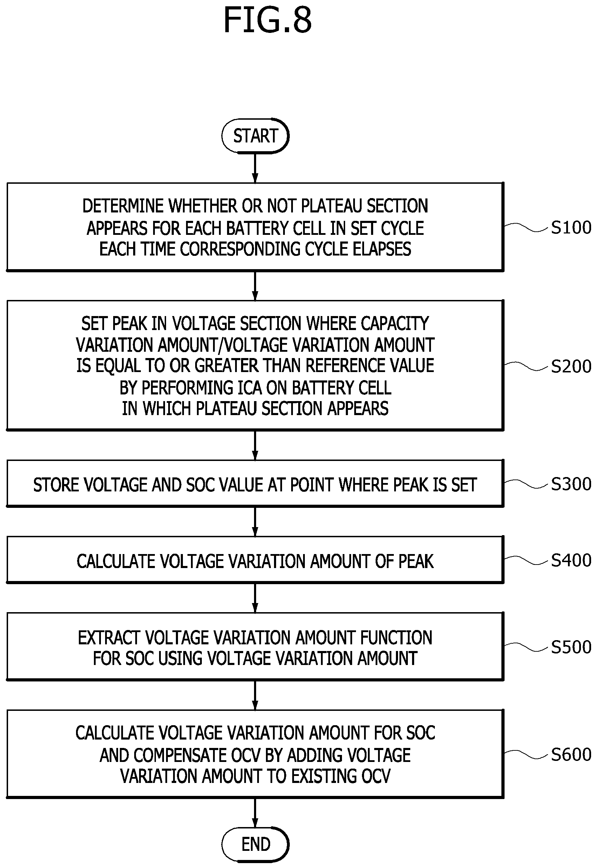

Hereinafter, a method for compensating an OCV of a battery according to embodiments of the present disclosure will be described with reference to FIG. 8.

FIG. 8 is a flowchart of a method for compensating an OCV of a battery according to one embodiment of the present disclosure.

Referring to FIG. 8, each time a preset set cycle elapses (e.g., each time a set number of charge or discharge cycles elapse), for example, each time 150 cycles elapse, the processor 500 may determine whether or not a plateau section appears for each battery cell 20 based on the voltage of each battery cell 20 detected by the voltage sensor 200 (S 100).

To this end, the processor 500 determines whether the voltage variation amount (e.g. change in the voltage) of the battery cell 20 in a corresponding cycle is less than or equal to a threshold. As a result of the determination, when the voltage variation amount of the battery cell 20 is less than or equal to the threshold, the processor 500 may determine that the plateau section appears in the corresponding battery cell 20.

The processor 500 may identify (e.g. set) a peak in a voltage section (e.g. a voltage range) where the capacity variation amount divided by the voltage variation amount is equal to or greater than a reference value (e.g. a preset reference value) by performing the ICA on the battery cell 20 in which the plateau section appears (S200).

As the peak is identified (e.g. set), the processor 500 may store a voltage and an SOC value at a point where the peak is identified (e.g. set) (S300).

When voltages and SOC values at points where peaks are set in a plurality of set cycles are stored, the processor 500 may calculate a voltage variation amount using the voltage of the peak at each cycle (S400).

For example, when two peaks are identified (e.g. set) in the 50th cycle and the voltages of the corresponding peaks are shifted in the 200th cycle, two voltage variation amounts dv1 and dv2 may be obtained from voltages of two peaks in the 50th cycle and voltages of two peaks in the 200th cycle after 150 cycles have elapsed.

The processor 500 determines (e.g. extracts) a voltage variation amount function for the SOC using the previously stored SOC value at each cycle (e.g. charge or discharge cycle) and the voltage variation amount between voltages in the cycles (S500).

That is, the processor 500 determines (e.g. extracts) the voltage variation amount function for the SOC value using two SOC values in the 50th cycle and two SOC values in the 200th cycle, and the voltage variation amount between the voltage in the 50th cycle and the voltage in the 200th cycle.

In this case, the processor 500 may use at least one of constant processing, interpolation/extrapolation, a cut method, and a curve fitting method depending on the number of peaks.

Then, the processor 500 calculates a voltage variation amount for each SOC value using the determined (e.g. extracted) voltage variation amount function, and compensates the OCV by adding the calculated voltage variation amount for each SOC to the OCV of the existing SOC value (S600).

Implementations described herein may be implemented as, for example, a method or process, device, software program, data stream, or signal. Although discussed only in the context of a single form of implementation (e.g., discussed only as a method), implementations of the features discussed may also be implemented in other forms (e.g., a device or a program). A device may be implemented with appropriate hardware, software, firmware, etc. A method may be implemented in a device such as a processor or the like, which generally refers to a processing device including a computer, a microprocessor, an integrated circuit, a programmable logic device, or the like. A processor also includes a communication device such as a computer, a cell phone, a personal digital assistant ("PDA"), and another device, that facilitates communication of information between end-users.

An apparatus and method for compensating an OCV of a battery according to aspects of the present disclosure can more simply and precisely compensate the OCV for an SOC according to an aging direction of a battery cell and improve performance of an algorithm for estimating a state of the battery cell.

Although the present disclosure has been described with reference to the embodiments illustrated in the drawings, it is merely an example, and it is to be understood to those skilled in the art that various modifications and equivalent other embodiments could be made therefrom. Therefore, the true technical protection scope of the present disclosure should be defined only by the claims below.

Examples are set out in the following numbered clauses:
1. An apparatus for compensating an open-circuit voltage (OCV) of a battery, the apparatus comprising:
   a voltage sensor configured to detect a voltage of a battery cell; and
   a processor configured to extract a voltage value and a state-of-charge (SOC) value of a peak within a preset voltage section for each preset set cycle based on a voltage value of the battery cell detected by the voltage sensor each time the preset set cycle elapses and compensate an OCV using the SOC value for each peak and a voltage variation amount of the peak.
2. The apparatus of clause 1, wherein the processor extracts the voltage value and the SOC value of the peak within the voltage section when a plateau section appears in the battery cell.
3. The apparatus of clause 1 or clause 2, wherein the processor extracts the peak in a voltage section where a capacity variation amount/voltage variation amount is equal to or greater than a preset reference value by utilizing incremental capacity analysis (ICA) during a constant current charging or discharging process of the battery cell.
4. The apparatus of any preceding clause, wherein the processor adds the voltage variation amount for the SOC value to an OCV value.
5. The apparatus of clause 4, wherein the processor extracts a voltage variation amount function for the SOC value and calculates the voltage variation amount for the SOC value using the voltage variation amount function.
6. The apparatus of clause 5, wherein the processor extracts the voltage variation amount function using at least one of constant processing, interpolation/extrapolation, a cut method, and curve fitting depending on the number of peaks.
7. The apparatus of clause 6, wherein the processor processes the voltage variation amount function as a constant when the number of peaks is one.
8. The apparatus of clause 6 or clause 7, wherein the processor extracts the voltage variation amount function through at least one of the interpolation/extrapolation, the cut method, and the curve fitting when the number of peaks is plural.
9. A method for compensating an OCV of a battery, the method comprising:
   extracting, by a processor, a voltage value and an SOC value of a peak within a preset voltage section for each cycle, based on a voltage value of a battery cell detected by a voltage sensor; and
   compensating, by the processor, the OCV using the SOC value for each peak and a voltage variation amount of the peak.
10. The method of clause 9, wherein in the extracting of the voltage value and the SOC value of the peak within the preset voltage section for each cycle, the processor extracts the voltage value and the SOC value of the peak within the voltage section when a plateau section appears in the battery cell.
11. The method of clause 9 or clause 10, wherein in the extracting of the voltage value and the SOC value of the peak within the preset voltage section for each cycle, the processor extracts the peak in a voltage section where a capacity variation amount/voltage variation amount is equal to or greater than a preset reference value by utilizing incremental capacity analysis (ICA) during a constant current charging or discharging process of the battery cell.
12. The method of any of clauses 9 to 11, wherein in the compensating of the OCV, the processor adds the voltage variation amount for the SOC value to an OCV value.
13. The method of clause 12, wherein in the compensating of the OCV, the processor extracts a voltage variation amount function for the SOC value and calculates the voltage variation amount for the SOC value using the voltage variation amount function.
14. The method of clause 13, wherein in the compensating of the OCV, the processor extracts the voltage variation amount function using at least one of constant processing, interpolation/extrapolation, a cut method, and curve fitting depending on the number of peaks.
15. The method of clause 14, wherein in the compensating of the OCV, the processor processes the voltage variation amount function as a constant when the number of peaks is one.

## Claims

1. An apparatus for compensating an open-circuit voltage (OCV) of a battery, the apparatus comprising:
a voltage sensor configured to detect a voltage of a battery cell of the battery; and
a processor configured to determine a voltage value and a state-of-charge (SOC) value of a peak within a voltage range based on the voltage of the battery cell each time a set number of cycles elapses, to determine a voltage variation amount of the peak, and to compensate an OCV using the SOC value for each peak and the voltage variation amount of the peak.

2. The apparatus of claim 1, wherein the processor is configured to determine the voltage value and the SOC value of the peak within the voltage range in response to a plateau section being identified in a variation of cell voltage over cell capacity corresponding to the battery cell.

3. The apparatus of claim 1 or claim 2, wherein the processor is configured to identify the peak in the voltage range in which a capacity variation amount divided by a voltage variation amount is equal to or greater than a reference value by utilizing incremental capacity analysis (ICA) during a constant current charging or discharging process of the battery cell.

4. The apparatus of any preceding claim, wherein the processor is configured to add the voltage variation amount for the SOC value to an OCV value.

5. The apparatus of claim 4, wherein the processor is configured to identify a voltage variation amount function corresponding to the SOC value and to calculate the voltage variation amount for the SOC value using the voltage variation amount function.

6. The apparatus of claim 5, wherein the processor is configured to identify the voltage variation amount function using at least one of constant processing, interpolation/extrapolation, a cut method, and a curve fitting method based on a number of peaks.

7. The apparatus of claim 6, wherein the processor is configured to process the voltage variation amount function as a constant in response to the number of identified peaks being one.

8. The apparatus of claim 6 or claim 7, wherein the processor is configured to identify the voltage variation amount function through at least one of the interpolation/extrapolation, the cut method, and the curve fitting method in response to the number of identified peaks being two or more.

9. A method for compensating an open-circuit voltage, OCV, of a battery, the method comprising:
determining, by a processor, a voltage value and an SOC value of a peak within a voltage range, based on a voltage value of a battery cell detected by a voltage sensor; and
compensating, by the processor, the OCV using the SOC value for the peak and a voltage variation amount of the peak.

10. The method of claim 9, wherein in the determining the voltage value and the SOC value of the peak within the voltage range for each cycle, the processor determines the voltage value and the SOC value of the peak within the voltage range in response to a plateau section being identified in the battery cell.

11. The method of claim 9, wherein in the determining the voltage value and the SOC value of the peak within the voltage range for each cycle, the processor identifies the peak in the voltage range in which a capacity variation amount divided by a voltage variation amount is equal to or greater than a reference value by utilizing incremental capacity analysis (ICA) during a constant current charging or discharging process of the battery cell.

12. The method of claim 9, wherein in the compensating of the OCV, the processor adds the voltage variation amount for the SOC value to an OCV value.

13. The method of claim 12, wherein in the compensating of the OCV, the processor determines a voltage variation amount function corresponding to the SOC value and calculates the voltage variation amount for the SOC value using the voltage variation amount function.

14. The method of claim 13, wherein in the compensating of the OCV, the processor determines the voltage variation amount function using at least one of constant processing, interpolation/extrapolation, a cut method, and a curve fitting method based on a number of identified peaks.

15. The method of claim 14, wherein in the compensating of the OCV, the processor processes the voltage variation amount function as a constant in response to the number of peaks being one.
